# FASCICULE DE BREVET EUROPEEN

(11) **EP 0 762 691 B1**
(45) Date de publication et mention de la délivrance du brevet: **16.04.2003**
(21) Numéro de dépôt: 96401890.7
(22) Date de dépôt: 04.09.1996
(51) Int. Cl.: H04J 14/02, H04B 10/17, H03G 3/30

(54) **Procédé et système d'égalisation des niveaux respectifs de puissance des canaux d'un signal optique spectralement multiplexé**
Verfahren und Vorrichtung zum Niveauausgleich der Leistung der Kanäle eines spektral gemultiplexten optischen Signals
Method and device for equalising the respective power levels of the channels of a spectrally multiplexed signal

(30) Priorité: 08.09.1995 FR 9510548
(43) Date de publication de la demande: 12.03.1997
(73) Titulaire: ALCATEL, 75382 Paris Cédex 08 (FR)
(72) Inventeur: Bayart, Dominique, 92140 Clamart (FR); Desthieux, Bertrand, 75014 Paris (FR)
(74) Mandataire: Fournier, Michel Robert Marie

(56) Documents cités:
- IEEE PHOTONICS TECHNOLOGY LETTERS, vol. 3, no. 8, 1 Août 1991, pages 718-720, XP000223738 KYO INOUE ET AL: "TUNABLE GAIN EQUALIZATION USING A MACH-ZEHNDER OPTICAL FILTER IN MULTISTAGE FIBER AMPLIFIERS"
- PATENT ABSTRACTS OF JAPAN vol. 016, no. 430 (P-1417), 9 Septembre 1992 & JP 04 147114 A (NIPPON TELEGR & TELEPH CORP), 20 Mai 1992,
- PATENT ABSTRACTS OF JAPAN vol. 016, no. 540 (P-1450), 10 Novembre 1992 & JP 04 204719 A (HITACHI LTD), 27 Juillet 1992,

## Description

L'invention concerne un procédé et un système d'égalisation des niveaux respectifs de puissance des canaux d'un signal optique spectralement multiplexé reçu transmis par l'intermédiaire d'une liaison amplifiée.

De manière connue, les liaisons de transmission à longue distance comportent des amplificateurs de régénération du signal transmis qui sont régulièrement répartis au long de ces liaisons.

Lorsqu'un signal optique spectralement multiplexé est transmis par une telle liaison amplifiée, il est préférable que les niveaux respectifs de puissance des différents canaux qu'il comporte soient et restent pratiquement identiques au long de cette transmission. Autrement, en l'absence de mesure particulière, le niveau de puissance du canal à niveau le plus faible d'un signal tend à se réduire par rapport aux niveaux de puissance des autres canaux de ce signal, au fur et à mesure de la transmission du signal au travers des amplificateurs optiques jalonnant la liaison considérée. Le rapport signal/bruit et la dynamique pour ce canal à niveau de puissance le plus faible peuvent alors devenir insuffisants pour une bonne exploitation de la partie de signal correspondant à ce canal, à la sortie de la liaison.

Une solution à ce problème est donnée dans le document intitulé "Self-regulating WDM amplifier module for scalable lightwave networks", de E.L. GOLDSTEIN & al, qui a été publié en août 1994 à BRECKENBRIDGE, COLORADO, dans le résumé technique 1994, volume 14, relatif aux "amplificateurs optiques et à leurs applications". Cet amplificateur auto-régulateur est destiné à éviter que les canaux qui ne sont pas dans la zone de pic de gain des amplificateurs optiques d'une liaison de transmission ne tombent à un trop faible niveau de puissance et que les parties correspondantes du signal transmis ne soient plus exploitables. Il comporte des amplificateurs optiques individuels à pompe partagée pour les divers canaux, ces amplificateurs sont placés entre un démultiplexeur recevant le signal optique spectralement multiplexé tel que transmis et un multiplexeur reconstituant ce signal, à partir de ce qui est fourni par les amplificateurs optiques individuels montés en parallèle, pour transmission plus avant par l'intermédiaire de la liaison considérée. Un tel amplificateur auto-régulateur qui permet d'équilibrer les niveaux de puissance pour les différents canaux d'un signal optique spectralement multiplexé présente l'inconvénient d'introduire des pertes relativement élevées tant lors du démultiplexage du signal reçu que lors du multiplexage du signal transmis et en conséquence une dégradation notable du rapport signal/bruit au niveau de ce dernier.

L'invention propose donc un procédé d'égalisation des niveaux de puissance respectifs des canaux d'un signal optique spectralement multiplexé.

Un tel procédé et système selon les préambules respectifs des revendications 1 et 4 sont déjà connus du document JP-A-4 204 719.

Selon une caractéristique de l'invention, ce procédé comporte les opérations suivantes:
- détermination du niveau de puissance de chaque canal du signal optique spectralement multiplexé;
- introduction d'une atténuation dans les canaux présentant des niveaux de puissance élevés par rapport à un niveau de référence correspondant soit au niveau de puissance du canal ayant le niveau de puissance le plus faible, soit à un niveau déterminé à partir des niveaux de puissance des canaux ayant des niveaux de puissance proches de celui du canal ayant le niveau de puissance le plus faible, l'atténuation apportée aux canaux présentant des niveaux de puissance élevés correspondant à la différence entre un niveau de puissance déduit des niveaux de puissance de ces canaux présentant des niveaux de puissance élevés et ledit niveau de référence.

L'invention propose aussi un système d'égalisation des niveaux de puissance respectifs des canaux d'un signal optique spectralement multiplexé reçu et transmis, notamment par une liaison de transmission à amplificateurs répartis.

Selon une caractéristique de l'invention, ce système comporte au moins un module égaliseur optique incluant:
- des moyens pour mesurer les niveaux respectifs de puissance optique des canaux du signal optique spectralement multiplexé que ce module reçoit et transmet;
- des moyens de traitement pour déterminer celui parmi les canaux du signal optique reçu qui a le niveau de puissance le plus faible en vue de la détermination d'un niveau de référence correspondant soit à ce niveau de puissance le plus faible, soit à un niveau déterminé à partir des canaux ayant des niveaux de puissance proches de ce niveau de puissance le plus faible, pour déterminer au moins une valeur d'atténuation destinée à être appliquée aux canaux présentant des niveaux de puissance élevés à partir de la différence entre un niveau de puissance déduit des niveaux de puissance de ces canaux présentant des niveaux de puissance élevés et le niveau de référence, si cette différence est supérieure à une valeur de seuil donnée;
- des moyens d'atténuation réglables, commandés par les moyens de traitement et aptes à agir séparément sur les niveaux de puissance des canaux de signal optique et introduire l'atténuation déterminée par les moyens de traitement dans chacun des canaux pour lesquels des niveaux de puissance élevés ont été mesurés, les moyens pour mesurer étant reliés aux moyens de traitement auxquels ils fournissent les mesures de niveau de puissance par canal, les moyens de traitement étant reliés aux moyens d'atténuation par l'intermédiaire de moyens d'interface permettant d'agir sur ces moyens d'atténuation pour obtenir que tous les canaux aient finalement au moins approximativement même niveau de puissance, en aval desdits moyens d'atténuation.

L'invention, ses caractéristiques et ses avantages sont précisés dans la description qui suit en liaison avec les figures évoquées ci-dessous.

La figure 1 présente, à titre d'exemple, un schéma synoptique montrant le positionnement d'un égaliseur optique selon l'invention dans un ensemble de télécommunications à liaisons de transmission à longue distance.

La figure 2 présente, à titre d'exemple, un schéma synoptique d'un agencement, pour liaison de transmission, qui incorpore un module de système d'égalisation optique selon l'invention.

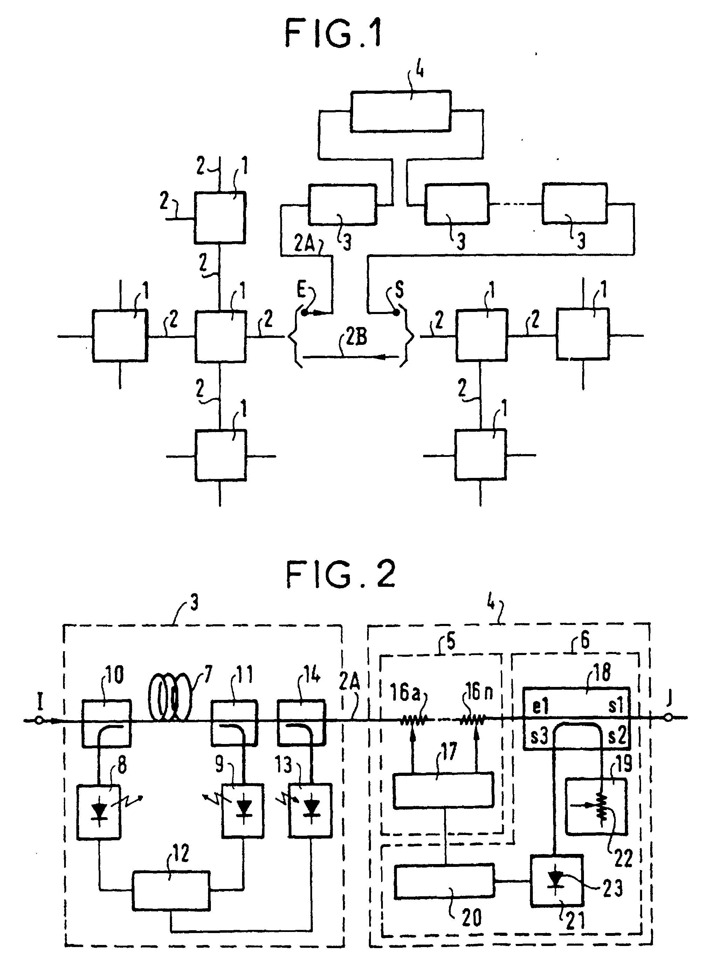

L'ensemble de télécommunications symbolisé en figure 1 est supposé constitué d'une pluralité de noeuds de télécommunications 1 communiquant en point-à-point entre eux et avec d'autres noeuds non représentés par l'intermédiaire de liaisons de transmission 2. Les liaisons de transmission 2 sont supposées être constituées chacune par au moins une liaison optique et plus généralement par au moins deux liaisons optiques unidirectionnelles assurant des transmissions en sens inverse, deux de ces liaisons optiques de sens inverse référencées 2A et 2B étant représentées pour une des liaisons de transmission 2 sur la figure 1. Une liaison de transmission 2 est supposée être destinée à relier deux noeuds de télécommunications 1 situés à grande distance l'un de l'autre. Il est alors nécessaire de disposer des amplificateurs optiques régulièrement répartis sur la longueur de chacune des liaisons optiques qui la forme cette liaison de transmission 2 pour combattre l'affaiblissement et la déformation des signaux optiques transmis. Ceci est symbolisé sur la figure 1 par la représentation d'une pluralité d'amplificateurs optiques 3 supposés répartis sur la longueur de la liaison optique 2A entre une extrémité d'entrée E et une extrémité de sortie S de cette liaison optique unidirectionnelle.

Comme il est connu, il existe des liaisons optiques et des amplificateurs optiques qui permettent d'assurer la transmission d'un signal optique, lorsque ce dernier est spectralement multiplexé et qu'il est donc constitué de canaux susceptibles d'être distingués. Ceci peut notamment permettre de transmettre des signaux optiques, ici dits primaires, qui ne proviennent pas nécessairement d'une même source, dans des canaux distincts d'un signal optique spectralement multiplexé et par l'intermédiaire d'une liaison optique. Ces signaux optiques primaires, qui proviennent par exemple de noeuds 2 différents, sont par exemple combinés au niveau du noeud 2 où se situe l'entrée E de la liaison optique considérée, pour former le signal optique spectralement multiplexé transmis. Il est préférable que les niveaux de puissance des signaux transmis par l'intermédiaire des différents canaux d'une même liaison optique soient égaux ou pratiquement égaux, en particulier pour que ces signaux soient amplifiés de manière identique, lorsque le signal optique spectralement multiplexé qu'ils composent, affaibli par sa transmission, est renforcé par les amplificateurs optiques répartis au long de la liaison optique considérée. Il existe donc un risque que les niveaux de puissance des signaux primaires fournis pour constituer un signal optique spectralement multiplexé destiné à être transmis par une liaison optique ne soient pas aussi identiques que souhaité. Il n'est pas non plus exclu que des signaux primaires simultanément transmis sous la forme d'un même signal optique spectralement multiplexé au long d'une liaison optique puissent présenter des niveaux de puissance suffisamment différents à partir d'un niveau ou d'un autre au long de cette liaison et qu'en conséquence le signal optique spectralement multiplexé transmis par l'entrée E de la liaison optique ne puisse être complètement retrouvé à la sortie S.

Il est donc prévu d'associer un système d'égalisation des niveaux de puissance, canal par canal. Ce système est susceptible d'être constitué d'un ou de plusieurs modules égaliseurs optiques disposés, suivant les besoins, au long du trajet suivi par un signal optique spectralement multiplexé et donc en particulier au long d'une liaison optique permettant la transmission de ce signal entre deux points. Ceci est symbolisé par la présence d'un module égaliseur optique 4 entre deux des amplificateurs optiques 3 que comporte la liaison optique unidirectionnelle 2A entre son entrée E et sa sortie S, sur la figure 1.

Pratiquement et notamment dans le type de réalisation envisagé ici, un module égaliseur optique 4 est préférablement localisé au niveau d'un amplificateur optique 3 auquel il est associé, entre deux tronçons successifs de la liaison optique considérée et donc à une extrémité de chacun de ces deux tronçons. Il serait bien entendu envisageable d'associer un module égaliseur optique 4 à chaque amplificateur optique 3, mais il apparaît que ceci sera généralement superflu.

Comme déjà indiqué plus haut, la figure 2 montre un exemple d'agencement, ici supposé de type modulaire, plus particulièrement destiné à équiper une liaison optique unidirectionnelle, telle 2A, d'une liaison de transmission 2, en un point de cette liaison optique par où se propage un signal optique spectralement multiplexé en une pluralité de canaux distincts. Ces canaux sont par exemple susceptibles d'être au nombre de seize et de correspondre respectivement à des ondes dont les longueurs d'onde centrales sont comprises entre 1530 et 1560 nm , ces longueurs d'onde centrales sont par exemple régulièrement espacées, cet espacement correspondant à une valeur choisie par exemple entre 0,3 et 4 nm.

La liaison optique 2A comporte par exemple une centaine d'amplificateurs 3 de régénération du signal optique spectralement multiplexé transmis qui sont régulièrement répartis sur sa longueur.

L'agencement présenté sur la figure 2 est supposé comporter un de ces amplificateurs optiques 3 qui est supposé inséré entre deux tronçons successifs de la liaison optique 2 de manière à recevoir le signal optique spectralement multiplexé d'un premier de ses tronçons par une entrée connectée en un point I de la liaison. Le signal optique spectralement multiplexé régénéré par l'amplificateur optique 3 est destiné à être réinjecté par une sortie de cet amplificateur en un point J dans le second des tronçons évoqués ci-dessus de la liaison optique 2A pour poursuite de sa transmission.

L'agencement présenté sur la figure 2 comporte de plus un module égaliseur optique 4 comportant un dispositif atténuateur optique 5 auquel est associé un dispositif de surveillance 6 chargé de déterminer les niveaux de puissance pour les différents canaux du signal optique spectralement multiplexé qu'il reçoit.

Dans l'exemple envisagé, le dispositif atténuateur optique 5 et le dispositif de surveillance 6 sont insérés en série entre la sortie de signal optique spectralement multiplexé de l'amplificateur 3 de l'agencement et le point J évoqué ci-dessus. Un isolateur optique unidirectionnel, non représenté, est susceptible d'être inséré entre le dispositif atténuateur optique 5 et le dispositif de surveillance 6 pour éviter toute transmission vers cet atténuateur des éventuelles réflexions parasites susceptibles de se produire dans le dispositif de surveillance.

Par ailleurs, il est envisageable de disposer les trois éléments constitutifs de l'agencement proposé ci-dessus que constituent l'amplificateur optique 3, le dispositif atténuateur optique 5 et le dispositif de surveillance 6 de manière différente, si besoin est.

L'amplificateur optique 3 est par exemple constitué par une fibre 7 dopée à l'erbium apte à amplifier un signal optique spectralement multiplexé reçu du point I. Cette amplification est supposée s'effectuer en réponse à une action d'une source de pompe typiquement constituée par deux diodes laser 8 et 9 qui injectent deux ondes de pompe dans la fibre 7 par l'intermédiaire de deux multiplexeurs 10 et 11 respectivement situés de part et d'autre de la fibre 7 sur le trajet suivi dans l'amplificateur 3 par le signal optique spectralement multiplexé. Un dispositif de régulation 12 fournit un courant d'alimentation aux diodes laser 8 et 9 en fonction de signaux de commande destinés permettre une régénération du signal optique spectralement multiplexé par une amplification appropriée.

Dans l'exemple envisagé, les signaux de commande fournis par le dispositif de régulation 12 sont au moins en partie déduits de mesures réalisées par l'intermédiaire d'une diode photodétectrice 13 recevant un signal optique de régulation capté par un coupleur optique 14 et attaquant sous forme électrique un montage amplificateur non représenté, ici supposé situé dans le dispositif de régulation 12. Le coupleur optique 14 est ici supposé placé en aval du coupleur 11 de manière à recevoir le signal optique amplifié.

Dans l'agencement proposé ici, le dispositif atténuateur optique 5 selon l'invention reçoit le signal optique spectralement multiplexé régénéré par l'amplificateur optique 3.

Un isolateur optique unidirectionnel, non représenté, est susceptible d'être inséré entre le dispositif atténuateur optique 5 et l'amplificateur optique 3 pour éviter toute transmission vers cet amplificateur des éventuelles réflexions parasites susceptibles de se produire dans le dispositif atténuateur.

Comme déjà indiqué, le dispositif atténuateur optique 5 pourrait être placé au niveau d'un autre point de passage du signal optique spectralement multiplexé au long de la liaison optique 2A, par exemple en avant un amplificateur optique en entrée de liaison optique 2A, ou encore après un dispositif de surveillance 6.

Dans une forme préférée de réalisation, le dispositif atténuateur optique 5 comporte des filtres accordables, préférablement de type réseau photoréfractif, tels 16a et 16n, qui sont disposés en série entre une entrée et une sortie de ce dispositif et qui sont destinés à permettre d'atténuer individuellement chacun un canal. Cette atténuation est ici supposée obtenue en agissant sur le coefficient de transmission par décalage de la longueur d'onde de BRAGG du réseau photoréfractif d'un filtre, tel 16a, par rapport à la longueur d'onde centrale du canal dont le niveau de puissance est à réduire par l'intermédiaire de ce filtre.

Dans une forme préférée de réalisation, où le réseau photoréfractif de chaque filtre est réalisé par gravure sur au moins une structure guide d'onde optique, par exemple une fibre optique, où circule le signal optique spectralement multiplexé. Dans une forme préférée de réalisation les filtres sont répartis sur plusieurs structures guides d'onde, de manière à pouvoir aisément être accordés de manière séparée. Il est prévu de commander par voie mécanique ou éventuellement thermique l'accord de chacun des filtres 16a à 16n, en fonction des mesures effectuées canal par canal par le dispositif de surveillance 6. Un agencement de conversion 17 reçoit alors les indications fournies par le dispositif de surveillance 6, sous forme électrique et agit en conséquence sur les filtres.

Cette action est susceptible d'être obtenue par déformation mécanique ou encore par modification de la température de la fibre au niveau des zones de fibre où sont réalisés les réseaux photoréfractifs. L'obtention d'une modification de la température d'une zone de fibre est susceptible d'être obtenue par mise en oeuvre de moyens bien connus de l'homme de métier.

L'accord d'un filtre par déformation mécanique peut être obtenu par application d'une pression, par exemple au moyen d'un dispositif piézo-électrique, dans la zone de fibre porteuse où se trouve le réseau de BRAGG constituant ce filtre.

L'accord d'un filtre par déformation mécanique peut également être obtenu par l'intermédiaire de moyens tels que définis dans la demande de brevet français n°9409705 (publiée sous le numéro FR-A-2 723 449). En particulier un tel accord peut être obtenu par élongation d'une longueur de fibre où est gravée le réseau de BRAGG d'un filtre, lorsque cette longueur de fibre est rendue solidaire d'un support qui est susceptible d'être soumis à des efforts de traction qui tendent à l'allonger et en conséquence à allonger le pas du réseau de BRAGG porté.

Un résultat analogue peut aussi être obtenu avec une longueur de fibre solidaire d'un support dont la cambrure est modifiée par application d'une pression mécanique transversale, cette variation de cambrure entraînant elle aussi une variation de l'allongement de la longueur de fibre considérée et en conséquence une variation du pas du réseau de BRAGG gravé sur cette longueur.

Ceci permet de diminuer sélectivement les niveaux de puissance des canaux ayant des niveaux élevés par rapport aux signaux plus faibles. Selon un procédé d'atténuation préféré qui est développé plus loin, les divers canaux voient leurs niveaux de puissance identiquement réduits à l'exception de celui qui a le niveau de puissance le plus faible.

Le dispositif de surveillance 6 est par exemple agencé de manière à prélever une petite portion, par exemple 1%, du signal optique qui lui est fourni, ici par la sortie du dispositif atténuateur optique 5. Ce prélèvement est prévu assuré par un coupleur optique 18 qui est par exemple obtenu par couplage des coeurs de deux fibres optiques par exemple par fusion au niveau d'une zone où se réalise le couplage.

La majeure partie du signal optique spectralement multiplexé reçu par ce coupleur optique 18 au niveau d'une entrée e1 est transmise par un accès de sortie directe s1 qu'il comporte et via la sortie du module égaliseur optique 4 qui le contient, vers le point J de la liaison optique 2A en vue de la poursuite de la transmission de ce signal.

Le dispositif de surveillance 6 comporte également des moyens d'extraction par filtrage 19 qui reçoivent la petite portion de signal optique prélevé par le coupleur optique 18, au travers d'une sortie de dérivation directe s2, afin d'extraire les parties de cette portion qui correspondent aux différents canaux du signal optique spectralement multiplexé transmis.

Ces moyens sont par exemple constitués par un filtre photoréfractif accordable non représenté qui est susceptible d'être analogue aux filtres accordables 16a, 16n évoqués plus haut et qui est commandé par une logique de gestion 20, ici supposée propre module égaliseur optique 4, mais éventuellement partagée et par exemple commune à ce module 4 et à l'amplificateur optique 3 auquel il est associé, par exemple au niveau du dispositif de régulation 12.

Le dispositif de surveillance 6 comporte encore des moyens de mesure de puissance optique 21 permettant de définir le niveau de puissance optique pour chacun des canaux dont une partie a été obtenue par filtrage par les moyens d'extraction par filtrage 19 de la portion de signal optique prélevée par le coupleur optique 18.

Ces moyens de mesure de puissance optique 21 sont par exemple de type photodétecteur. Dans l'exemple envisagé plus haut où les moyens d'extraction par filtrage 19 sont constitués par un filtre photoréfractif accordable 22 raccordé à la sortie de dérivation directe s2 du coupleur optique 18, les moyens de mesure de puissance optique 21 sont constitués par un photodétecteur unique 23 qui reçoit par l'intermédiaire d'un accès réflexif s3 du coupleur optique 18 tout signal optique réfracté par le filtre photoréfractif accordable 22. Ce photodétecteur 23 fournit alors un signal sous forme électrique à destination de la logique de gestion 20 en fonction du niveau de puissance du signal qu'il reçoit pour un réglage donné du filtre photoréfractif 22 auquel il est optiquement couplé. La logique de gestion 20 agit sur le filtre photoréfractif 22 d'une manière qui correspond à celle par laquelle elle agit sur les filtres 16a, 16n pour en modifier l'accord, selon les besoins.

L'égalisation d'un signal optique spectralement multiplexé comportant n canaux et transitant par un module égaliseur optique 4 tel que décrit ci-dessus est susceptible d'être réalisée selon le processus suivant. Ce processus peut éventuellement être répété jusqu'à obtention du résultat recherché, si besoin est.

En premier, les moyens de mesure de puissance optique 21 déterminent le niveau de puissance pour chacun des n canaux du signal alors reçu par le module égaliseur optique 4.

Les n niveaux de puissance sont successivement mesurés par le photodétecteur 23 dans le cas où les moyens de mesure de puissance optique 21 ne comportent que ce seul photodétecteur. A cet effet, le filtre photoréfractif accordable 22 des moyens d'extraction par filtrage 19 est successivement accordé de manière à successivement réfléchir chacun des parties propres à chacun des n canaux de la petite portion de signal optique spectralement multiplexé que prélève le coupleur optique 18. Chacune des n parties centrée sur la fréquence centrale d'un canal différent est transmise au travers du coupleur optique 18 vers le photodétecteur 23 à partir du filtre photoréfractif accordable 22 qui est donc spécifiquement et successivement accordé sous le contrôle de la logique de gestion 20, en vue de la sélection et de la retransmission en sens inverse de chacune des parties.

Il est bien entendu envisageable de réaliser un module égaliseur optique 4 qui, comme indiqué plus haut, permet d'obtenir simultanément les niveaux de puissance pour les n canaux d'un même signal.

Les niveaux de puissance mesurés au cours d'une même opération pour les n canaux d'un signal optique spectralement multiplexé par les moyens de mesure de puissance optique 21 sont transmis à la logique de gestion 20 qui est supposé comporter des moyens matériels ou logiciels lui permettant de les traiter et par exemple de classer les canaux en fonction de leurs niveaux de puissance respectifs ou encore de déterminer quel est celui des n canaux simultanément ou quasi-simultanément mesurés qui a le niveau le plus faible.

Lorsque la logique de gestion 20 assure la détermination de celui des canaux d'un signal reçu dont le niveau de puissance est le plus faible, elle assure aussi la détermination de la différence Δp existant entre ce niveau le plus faible et un niveau de puissance moyen Pavg obtenu à partir des niveaux de puissance des autres canaux. Elle commande alors les filtres 16a à 16n du dispositif atténuateur optique 5 de manière que chacun d'eux introduise une atténuation, correspondant à la valeur de la différence Ap alors déterminée, dans les n-1 canaux autres que celui qui a le niveau le plus bas du signal optique spectralement multiplexé qui est propagé par le dispositif atténuateur optique vers le point J de la liaison optique 2A pour poursuite de sa transmission.

Comme déjà indiqué à plus haut, l'opération est susceptible d'être répétée si besoin est. Dans une forme préférée de réalisation, la logique de gestion 20 est susceptible d'interrompre les opérations d'égalisation dès que la différence Δp déterminée est inférieure à une valeur de seuil de fin d'opération et de les reprendre dès que cette différence dépasse une valeur de seuil de reprise, éventuellement identique à la précédente.

Bien entendu, la logique de gestion 20 peut aussi permettre de n'atténuer que certains des n canaux d'un signal optique spectralement multiplexé, si plusieurs canaux présentent simultanément des niveaux individuels de puissance qui peuvent être considérés comme correspondant pratiquement au niveau le plus faible alors déterminé.

En variante, la logique de gestion 20 et le dispositif atténuateur optique 5 peuvent aussi être organisés pour qu'il soit possible d'obtenir des atténuations différentes pour les canaux d'un signal optique spectralement multiplexé qui présentent les niveaux de puissance les plus élevés, si ces niveaux sont susceptibles d'être considérés comme appartenant à des sous-gammes différentes de niveau de puissance de la gamme de niveaux de puissance optique prévue pour les canaux. Deux niveaux d'atténuation différents pourraient par exemple être prévus dans le cas où deux sous-gammes de niveau de puissance pourraient être déterminés pour les canaux pour lesquels une atténuation est envisagée.

Dans la mesure où comme indiqué sur la figure 1, une même liaison optique, telle que 2A, est susceptible de comporter une pluralité d'amplificateurs optiques 3 régulièrement répartis sur sa longueur et au moins un module égaliseur optique 4 inséré entre deux de ces amplificateurs optiques, il est prévu de profiter des possibilités d'amplification d'au moins un des amplificateurs optiques situés en aval d'un module égaliseur 4 pour relever le niveau de puissance du signal optique spectralement multiplexé transmis par un module égaliseur 4 au niveau nominal prévu, si besoin est.

En cas d'introduction d'une atténuation à des fins d'égalisation dans un ou plusieurs canaux du signal optique spectralement multiplexé transitant par un module égaliseur 4, le niveau du signal optique spectralement multiplexé est susceptible d'être affaibli au dessous d'un niveau nominal prévu au niveau de la liaison. Ce niveau affaibli est alors rehaussé par le ou éventuellement les amplificateurs optiques 3 qui suive(nt) successivement le module égaliseur optique 4 considéré jusqu'à celui de ces amplificateurs où le niveau nominal prévu est retrouvé.

## Revendications

1. Procédé d'égalisation des niveaux de puissance respectifs des canaux d'un signal optique spectralement multiplexé, **caractérisé en ce qu'**il comporte les opérations suivantes:
- détermination du niveau de puissance de chaque canal du signal optique spectralement multiplexé;
- introduction d'une atténuation dans les canaux présentant des niveaux de puissance élevés par rapport à un niveau de référence correspondant soit au niveau de puissance du canal ayant le niveau de puissance le plus faible, soit à un niveau déterminé à partir des niveaux de puissance des canaux ayant des niveaux de puissance proches de celui du canal ayant le niveau de puissance le plus faible,
l'atténuation apportée aux canaux présentant des niveaux de puissance élevés correspondant à la différence entre un niveau de puissance déduit des niveaux de puissance de ces canaux présentant des niveaux de puissance élevés et ledit niveau de référence.

2. Procédé selon la revendication 1, **caractérisé en ce que** l'atténuation apportée aux canaux présentant des niveaux de puissance élevés par rapport au niveau de référence constitué par le niveau de puissance du canal ayant le niveau de puissance le plus faible, correspond à la différence entre un niveau de puissance moyen déterminé à partir des niveaux de puissance des canaux présentant des niveaux de puissance élevés et ledit niveau de référence.

3. Procédé selon la revendication 2, **caractérisé en ce qu'**il applique à tous les canaux, à l'exception du canal ayant le niveau de puissance le plus faible, une atténuation correspondant à la différence entre un niveau de puissance moyen, déterminé à partir des niveaux de puissance des canaux autres que le canal ayant le niveau de puissance le plus faible, et le niveau de référence constitué par ce niveau de puissance le plus faible.

4. Système d'égalisation des niveaux de puissance respectifs des canaux d'un signal optique spectralement multiplexé reçu et transmis, **caractérisé en ce qu'**il comporte au moins un module égaliseur optique (4) incluant:
- des moyens (18, 19, 21) pour mesurer les niveaux respectifs de puissance optique des canaux du signal optique spectralement multiplexé que ce module reçoit et transmet;
- des moyens (20) de traitement pour déterminer celui parmi les canaux du signal optique reçu qui a le niveau de puissance le plus faible en vue de la détermination d'un niveau de référence correspondant soit à ce niveau de puissance le plus faible, soit à un niveau déterminé à partir des canaux ayant des niveaux de puissance proches de ce niveau de puissance le plus faible, pour déterminer au moins une valeur d'atténuation destinée à être appliquée aux canaux présentant des niveaux de puissance élevés à partir de la différence entre un niveau de puissance déduit des niveaux de puissance de ces canaux présentant des niveaux de puissance élevés et le niveau de référence, si cette différence est supérieure à une valeur de seuil donnée;
- des moyens (5) d'atténuation réglables, commandés par les moyens de traitement et aptes à agir séparément sur les niveaux de puissance des canaux de signal optique et introduire l'atténuation déterminée par les moyens de traitement dans chacun des canaux pour lesquels des niveaux de puissance élevés ont été mesurés, les moyens pour mesurer étant reliés aux moyens de traitement auxquels ils fournissent les mesures de niveau de puissance par canal, les moyens de traitement étant reliés aux moyens d'atténuation par l'intermédiaire de moyens (17) d'interface permettant d'agir sur ces moyens d'atténuation pour obtenir que tous les canaux aient finalement au moins approximativement même niveau de puissance, en aval desdits moyens d'atténuation.

5. Système, selon la revendication 4, **caractérisé en ce qu'**il comporte un module égaliseur optique dont les moyens d'atténuation incluent au moins un filtre photoréfractif accordable (16a) dont la fréquence centrale est réglable de manière à pouvoir être accordé par les moyens de traitement dans une gamme de longueurs d'onde correspondant à celles des canaux du signal optique spectralement multiplexé qui est reçu et transmis par la liaison comportant ce module.

6. Système, selon la revendication 4, **caractérisé en ce qu'**il comporte un module égaliseur optique dont les moyens d'atténuation incluent un filtre photoréfractif accordable (16a, 16n) par canal, chaque filtre ayant une fréquence centrale réglable de manière à pouvoir être accordé par les moyens de traitement dans une gamme de longueurs d'onde correspondant à au moins une partie de celle que se partagent les canaux du signal optique spectralement multiplexé qui est reçu et transmis par la liaison comportant ce module.

7. Système, selon l'une des revendications 5, 6, **caractérisé en ce qu'**il comporte un module égaliseur optique dont les moyens d'atténuation incluent un ou des filtre(s) photoréfractif(s) accordable(s), dit(s) de BRAGG.

8. Système, selon la revendication 4, **caractérisé en ce qu'**il comporte un module égaliseur optique dont les moyens d'atténuation incluent des filtres photoréfractifs accordables (16a), notamment des filtres de BRAGG, qui sont disposés en série au long d'une structure guide d'onde optique, notamment de type fibre.

9. Système, selon la revendication 8, **caractérisé en ce qu'**il comporte un module égaliseur optique dont les moyens d'atténuation incluent des filtres photoréfractifs accordables (16a), notamment des filtres de BRAGG, qui sont disposés en série tout en étant répartis sur plusieurs structures guides d'onde, notamment plusieurs fibres optiques, de manière à pouvoir être individuellement accordés par déformation mécanique ou par variation de la température de la structure ou fibre qui le porte.

10. Système, selon la revendication 9, **caractérisé en ce qu'**il comporte un module égaliseur optique dont les moyens d'atténuation incluent des filtres photoréfractifs accordables (16a), notamment des filtres de BRAGG, répartis sur des structures guides d'onde, notamment des fibres optiques, qui sont associées à des moyens d'interface (17) permettant de les déformer sélectivement, par élongation ou par pression, sous la commande des moyens de traitement (20) pour assurer les réglages d'accord de ces filtres.

11. Système selon au moins l'une des revendications 4 à 10, **caractérisé en ce qu'**il comporte un module égaliseur optique dont les moyens pour mesurer les niveaux respectifs de puissance optique des canaux du signal optique spectralement multiplexé reçu incluent:
- un coupleur optique (18) pour prélever par couplage une petite portion du signal optique spectralement multiplexé reçu et à surveiller;
- des moyens (19) pour extraire par filtrage la partie correspondant à chaque canal dans une portion de signal prélevée qui comprennent au moins un filtre photoréfractif (22) dont la fréquence centrale est réglable de manière à pouvoir être accordée dans une gamme de longueurs d'onde correspondant à celles des canaux du signal optique spectralement multiplexé qui est reçu et transmis par la liaison comportant ce module;
et des moyens (21) de mesure de puissance optique, qui comprennent au moins un photodétecteur (13) associé au ou à l'un des filtre(s) photoréfractif(s) accordable(s) par l'intermédiaire du coupleur optique (18) qui prélève une portion dudit signal optique spectralement multiplexé, pour mesurer le niveau de puissance optique par canal dans la portion de signal prélevée .

## Claims

1. A method of equalizing respective power levels of channels of an optical frequency division multiplexed signal, **characterized in that** it includes the following operations:
- determining the power level of each channel of the optical frequency division multiplexed signal;
- introducing attenuation iasto the channels having power levels that are high relative to a reference level corresponding either to the power level of the channel having the lowest power level or to a level determined from the power levels of the channels having power levels near to that of the channel having the lowest power level, the attenuation applied to the channels having high power levels corresponding to the difference between a power level deduced from the power levels of said channels having high power levels and said reference level.

2. The method according to claim 1 **characterized in that** the attenuation applied to the channels having power levels that are high relative to the reference level consisting of the power level of the channel having the lowest power level corresponds to the difference between an average power level determined from the power levels of the channels having high power levels and said reference level.

3. The method according to claim 2 **characterized in that** attenuation is applied to all of the channels except for the channel having the lowest power level corresponding to the difference between an average power level determined from the power levels of the channels other than the channel having the lowest power level and the reference power level consisting of said lowest power level.

4. A system for equalizing power levels of channels of an optical frequency division multiplexed signal received and transmitted, **characterized in that** it includes at least one optical equalizer module (4) including:
- means (18, 19, 21) for measuring optical power levels of channels of the optical frequency division multiplexed signal that said module receives and transmits;
- processing means (20) for determining which channel of the received optical signal has the lowest power level for the purpose of determining a reference level corresponding either to said lowest power level or to a level determined from channels having power levels near said lowest power level, to determine at least one attenuation value to be applied to the channels having high power levels from the difference between a power level deduced from the power levels of said channels having high power levels and the reference level, if said difference is greater than a given threshold value;
- variable attenuation means (5) controlled by the processing means and adapted to operate separately on the power levels of the optical signal channels and to introduce the attenuation determined by the processing means into each of the channels for which high power levels have been measured, the measuring means being connected to the processing means to which they supply the measured power level of each channel, the processing means being connected to the attenuator means via interface means (17) for operating on said attenuation means so that all of the channels are finally at a power level that is at least approximately the same, on the downstream side of said attenuation means.

5. A system according to claim 4 **characterized in that** it includes an optical equalizer module the attenuation means of which include at least one tunable light refracting filter (16a) the centre frequency of which is variable so that it can be tuned by the processing means over a range of wavelengths corresponding to those of the channels of the optical frequency division multiplexed signal that is received and transmitted by the link including that module.

6. A system according to claim 4 **characterized in that** it includes an optical equalizer module the attenuation means of which include a tunable light refracting filter (16a, 16n) for each channel, each filter having a centre frequency that is variable so that it can be tuned by the processing means over a range of wavelengths corresponding to at least a part of that shared by the channels of the optical frequency division multiplexed signal that is received and transmitted by the link including that module.

7. A system according to either of claims 5 and 6, **characterized in that** it includes an optical equalizer module the attenuator means of which include one or more tunable Bragg light refracting filters.

8. A system according to claim 4 **characterized in that** it includes an optical equalizer module the attenuator means of which include tunable light refracting filters (16a), for example Bragg filters, disposed in series along an optical waveguide structure, for example of the fibre type.

9. A system according to claim 8 **characterized in that** it includes an optical equalizer module the attenuator means of which include tunable light refracting filters (16a), for example Bragg filters, disposed in series and distributed between a plurality of waveguide structures, for example a plurality of optical fibres, so that they can be individually tuned by mechanical deformation or by variation of the temperature of the structure or fibre carrying them.

10. A system according to claim 9 **characterized in that** it includes an optical equalizer module the attenuator means of which include tunable light refracting filters (16a), for example Bragg filters, distributed between waveguide structures, for example optical fibres, associated with interface means (17) enabling them to be deformed selectively, by stretching or by pressure, under the control of the processing means (20), in order to vary the tuning of said filters.

11. A system according to at least one of claims 4 to 10 **characterized in that** it includes an optical equalizer module the means in which for measuring the respective optical power levels of the channels of the optical frequency division multiplexed signal received include:
- an optical coupler (18) for sampling by coupling a small portion of the optical frequency division multiplexed signal received and to be monitored;
- filter means (19) for extracting the part corresponding to each channel in a sampled signal portion that comprise at least one light refracting filter (22) the centre frequency of which is variable so that it can be tuned over a range of wavelengths corresponding to those of the channels of the optical frequency division multiplexed signal received and transmitted by the link including said module;
and optical power measuring means (21) that comprise at least one photodetector (13) associated with the or one of the tunable light refracting filter(s) via the optical coupler (18) which samples a portion of said optical frequency division multiplexed signal to measure the optical power level for each channel in the sampled signal portion.

## Patentansprüche

1. Verfahren zum Niveauausgleich der Leistungen der Kanäle eines spektral gemultiplexten optischen Signals, **dadurch gekennzeichnet, dass** es die folgenden Schritte umfasst:
- Bestimmen des Leistungsniveaus jedes Kanals des spektral gemultiplexten optischen Signals;
- Herbeiführen einer Dämpfung in den Kanälen, die hohe Leistungsniveaus in Bezug auf ein Referenzniveau haben, das dem Leistungsniveau des Kanals mit dem niedrigsten Leistungsniveau oder einem Niveau entspricht, das anhand der Leistungsniveaus der Kanäle festgelegt ist, die Leistungsniveaus nahe dem des Kanals mit dem niedrigsten Leistungsniveau haben,
wobei die an den Kanälen mit hohen Leistungsniveaus herbeigeführte Dämpfung der Differenz zwischen einem von den Leistungsniveaus dieser Kanäle mit hohen Leistungsniveaus abgeleiteten Leistungsniveau und dem Referenzniveau entspricht.

2. Verfahren nach Anspruch 1, **dadurch gekennzeichnet, dass** die an den Kanälen mit hohen Leistungsniveaus im Bezug auf das durch das Leistungsniveau des Kanals mit dem niedrigsten Leistungsniveau gebildete Referenzniveau herbeigeführte Dämpfung der Differenz zwischen einem anhand der Leistungsniveaus der Kanäle mit hohen Leistungsniveaus festgelegten mittleren Leistungsniveau und dem Referenzniveau entspricht.

3. Verfahren nach Anspruch 2, **dadurch gekennzeichnet, dass** es auf alle Kanäle mit Ausnahme des Kanals mit dem niedrigsten Leistungsniveau eine Dämpfung anwendet, die der Differenz zwischen einem mittleren Leistungsniveau, das anhand der Leistungsniveaus der anderen Kanäle als desjenigen Kanals mit dem niedrigsten Leistungsniveau festgelegt wird, und dem durch das niedrigste Leistungsniveau gebildeten Referenzniveau entspricht.

4. System zum Ausgleichen der jeweiligen Leistungsniveaus der Kanäle eines empfangenen und übertragenen, spektral gemultiplexten optischen Signals, **dadurch gekennzeichnet, dass** es wenigstens ein optisches Ausgleichsmodul (4) umfasst, welches enthält:
- Mittel (18, 19, 21) zum Messen der jeweiligen Niveaus der optischen Leistung der spektral gemultiplexten optischen Kanäle, die dieses Modul empfängt und sendet;
- Verarbeitungsmittel (20) zum Bestimmen desjenigen unter den Kanälen des empfangenen optischen Signals, der das niedrigste Leistungsniveau hat, um ein Referenzniveau festzulegen, das diesem niedrigsten Leistungsniveau oder einem Leistungsniveau entspricht, das anhand der Kanäle mit Leistungsniveaus, die nahe an diesem niedrigsten Leistungsniveau liegen, festgelegt ist, um wenigstens einen Dämpfungswert, der vorgesehen ist, um auf die Kanäle mit hohen Leistungsniveaus angewandt zu werden, anhand der Differenz zwischen einem Leistungsniveau, das von den Leistungsniveaus dieser Kanäle mit hohen Leistungsniveaus abgeleitet wird, und dem Referenzniveau festzulegen, wenn diese Differenz größer als ein gegebener Schwellwert ist;
- regelbare Dämpfungsmittel (5), die durch die Verarbeitungsmittel gesteuert sind und in der Lage sind, getrennt auf die Leistungsniveaus der Kanäle des optischen Signals einzuwirken und die von den Verarbeitungsmitteln festgelegte Dämpfung in jedem der Kanäle, für die hohe Leistungsniveaus gemessen worden sind, herbeizuführen, wobei die Mittel zum Messen mit den Verarbeitungsmitteln, denen sie die Messwerte des Leistungsniveaus pro Kanal liefern, verbunden sind, die Verarbeitungsmittel mit den Dämpfungsmitteln über Schnittstellenmittel (17) verbunden sind, die es erlauben, auf die Dämpfungsmittel einzuwirken, um zu erreichen, dass jenseits der Dämpfungsmittel alle Kanäle schließlich wenigstens ungefähr gleiches Leistungsniveau haben.

5. System nach Anspruch 4, **dadurch gekennzeichnet, dass** es ein optisches Ausgleichsmodul umfasst, dessen Dämpfungsmittel wenigstens ein abstimmbares photorefraktives Filter (16a) umfassen, dessen Mittenfrequenz so regelbar ist, dass sie durch die Verarbeitungsmittel in einem Bereich von Wellenlängen abstimmbar ist, die denen des spektral gemultiplexten optischen Signals entsprechen, das von der dieses Modul aufweisenden Verbindung empfangen und übertragen wird.

6. System nach Anspruch 4, **dadurch gekennzeichnet, dass** es ein optisches Ausgleichsmodul umfasst, dessen Dämpfungsmittel ein abstimmbares photorefraktives Filter (16a, 16n) pro Kanal umfassen, wobei jedes Filter eine regelbare Mittenfrequenz hat, um von den Verarbeitungsmitteln in einem Wellenlängenbereich abgestimmt werden zu können, der wenigstens einem Teil desjenigen entspricht, den sich die Kanäle des spektral gemultiplexten optischen Signals teilen, das von der dieses Modul aufweisenden Verbindung empfangen und übertragen wird.

7. System nach einem der Ansprüche 5 oder 6, **dadurch gekennzeichnet, dass** es ein optisches Ausgleichsmodul umfasst, dessen Dämpfungsmittel ein oder mehrere abstimmbare photorefraktive sogenannte Bragg-Filter enthalten.

8. System nach Anspruch 4, **dadurch gekennzeichnet, dass** es ein optisches Ausgleichsmodul umfasst, dessen Dämpfungsmittel abstimmbare photorefraktive Filter (16a), insbesondere Bragg-Filter, enthalten, die in Reihe entlang einer optischen Wellenleiterstruktur, insbesondere vom Fasertyp, angeordnet sind.

9. System nach Anspruch 8, **dadurch gekennzeichnet, dass** es ein optisches Ausgleichsmodul umfasst, dessen Dämpfungsmittel abstimmbare photorefraktive Filter (16a), insbesondere Bragg-Filter, enthalten, die in Reihe angeordnet und dabei auf mehrere Wellenleiterstrukturen, insbesondere mehrere optische Fasern, verteilt sind, um individuell durch mechanische Verformung oder Veränderung der Temperatur der sie tragenden Struktur oder Faser abgestimmt werden zu können.

10. System nach Anspruch 9, **dadurch gekennzeichnet, dass** es ein optisches Ausgleichsmodul umfasst, dessen Dämpfungsmittel abstimmbare photorefraktive Filter (16a), insbesondere Bragg-Filter, enthalten, die auf Wellenleiterstrukturen, insbesondere optische Fasern, verteilt sind, die Schnittstellenmitteln (17) zugeordnet sind, die es ermöglichen, sie selektiv durch Streckung oder Druck unter der Steuerung von Verarbeitungsmitteln (20) zu verformen, um die Abstimmregelung dieser Filter zu gewährleisten.

11. System nach wenigstens einem der Ansprüche 4 bis 10, **dadurch gekennzeichnet, dass** es ein optisches Ausgleichsmodul umfasst, dessen Mittel zum Messen der jeweiligen optischen Leistungsniveaus der Kanäle des empfangenen spektral gemultiplexten optischen Signals enthalten:
- einen optischen Koppler (18) zum Abgreifen eines kleinen Anteils des empfangenen und zu überwachenden spektral gemultiplexten optischen Signals durch Kopplung;
- Mittel (19) zum Extrahieren des jedem Kanal entsprechenden Teils in einem abgegriffenen Signalanteil, die wenigstens ein photoretraktives Filter (22) umfassen, dessen Mittenfrequenz so regelbar ist, dass es in einem Bereich von Wellenlängen abstimmbar ist, die denen des spektral gemultiplexten optischen Signals entsprechen, das von der dieses Modul aufweisenden Verbindung empfangen und übertragen wird; und
- Mittel (21) zum Messen der optischen Leistung, die wenigstens einen Photodetektor (13) umfassen, der dem oder einem der abstimmbaren photorefraktiven Filter über den optischen koppler (18) zugeordnet ist, der einen Anteil des spektral gemultiplexten optischen Signals abgreift, um das optische Leistungsniveau pro Kanal in dem abgegriffenen Signalanteil zu messen.
